Europäisches Patentamt

European Patent Office

Office européen des brevets

(11) Publication number: **0 151 875**
**B1**

(12) EUROPEAN PATENT SPECIFICATION

(45) Date of publication of patent specification: **07.11.90**

(21) Application number: **84308520.0**

(22) Date of filing: **07.12.84**

(51) Int. Cl.⁵: **H 03 K 5/13**

(54) Gate circuit device.

(30) Priority: **09.12.83 JP 232531/83**
**20.07.84 JP 149587/84**

(43) Date of publication of application:
**21.08.85 Bulletin 85/34**

(45) Publication of the grant of the patent:
**07.11.90 Bulletin 90/45**

(84) Designated Contracting States:
**DE FR GB**

(56) References cited:
**EP-A-0 083 208**
**EP-A-0 087 707**

**IBM JOURNAL OF RESEARCH AND
DEVELOPMENT, vol. 25, no. 3, May 1981, pages
131-141, New York, US; E. BERNDLMAIER et al.:
"Delay regulation-A circuit solution to the
power/performance Tradeoff"**

(73) Proprietor: **FUJITSU LIMITED**
**1015, Kamikodanaka Nakahara-ku
Kawasaki-shi Kanagawa 211 (JP)**

(72) Inventor: **Suzuki, Hirokazu c/o Fujitsu Ltd.
Patent Department 1015 Kamikodanaka
Nakahara-ku Kawasaki 211 (JP)**
Inventor: **Akiyama, Takehiro c/o Fujitsu Ltd.
Patent Department 1015 Kamikodanaka
Nakahara-ku Kawasaki 211 (JP)**
Inventor: **Morita, Teruo c/o Fujitsu Ltd.
Patent Department 1015 Kamikodanaka
Nakahara-ku Kawasaki 211 (JP)**
Inventor: **Takeda, Hirofumi
c/o Fujitsu Ltd. 1015 Kamikodanaka
Nakahara-ku Kawasaki 211 (JP)**
Inventor: **Masunaga, Hikotaro
Patent Department 1015 Kamikodanaka
Nakahara-ku Kawasaki 211 (JP)**

(74) Representative: **Sunderland, James Harry et al
HASELTINE LAKE & CO Hazlitt House 28
Southampton Buildings Chancery Lane
London WC2A 1AT (GB)**

Courier Press, Leamington Spa, England.

# EP 0 151 875 B1

(56) References cited:

**IBM TECHNICAL DISCLOSURE BULLETIN, vol. 16, no. 11, April 1974, pages 3498-3500, New York, US; P.T. MARINO: "Variable delay pulse circuits"**

**IEEE ELECTRO, vol. 7, May 1982, pages 1-8(10/2), New York, US; B. GILLINGS: "New design techniques yield very high speed bipolar 8-and 12-bit microprocessor compatible analog-to-digital converters"**

**PROCEEDINGS OF THE INTERNATIONAL SYMPOSIUM ON MULTIPLE-VALUED LOGIC, Logan, Utah, 25th-28th May 1976, pages 30-42, IEEE, Long Beach, US; K.C. SMITH: "Circuits for multiple valued logic - a tutorial and apprecation"**

## Description

The present invention relates to a gate circuit device.

For example, a test apparatus for testing integrated circuits (to be called an IC tester hereafter) is provided with a number of output signal pins from which pins various output signals from the tester are supplied to an integrated circuit under test in order to check output conditions of the integrated circuit. In such case, it is sometimes desired to apply the various output signals simultaneously or with time intervals therebetween. However, since circuits in the tester which generate the various signals are formed in various manners, with different numbers of gates for example, the various signals may be generated at times or with time intervals which vary considerably, with timing differences in the order of nanoseconds (ns).

IBM Journal of Research and Development, Vol. 25, No. 3, May 1981, pages 131-141, "Delay Regulation A Circuit Solution to the Power/Performance Tradeoff" discloses delay regulation in an ECL circuit effected by varying the current switch current of the circuit. A similar circuit is disclosed in IBM Technical Disclosure Bulletin, Vol. 16, No. 11, April 1974, pages 3498 to 3450.

IEEE Electro, Vol. 7, May 1982, pages 1 to 8 (10/2), "New design techniques yield very high speed bipolar 8- and 12-bit microprocessor compatible analog-to-digital converters", discloses an ECL gate circuit in which the bases of current source transistors in an ECL circuit and in emitter followers are supplied in common with a voltage VBIAS (1.2 V).

IEEE Proceedings of the International Symposium on Multiple-valued Logic, May 25-28, 1976, Proc. 6, pages 30 to 42, in an article by Kenneth C. Smith entitled "Circuits for multiple-valued logic — a tutorial and appreciation", mentions inter alia ECL circuitry and discloses (Fig. 22) a five-valued storage element using ECL techniques. This storage element has a pair of emitter coupled transistors and emitter follower output circuitry with separate current sources.

According to the present invention there is provided a gate circuit device comprising:

a gate circuit having a pair of emitter coupled transistors, a first constant current source transistor connected to the emitter side of said emitter coupled transistors, emitter follower output level circuitry connected to the collector of one of said emitter coupled transistors, a second constant current source transistor provided in said emitter follower output level circuitry, and characterised by a terminal means arranged for receiving a selectively variable control signal, from outside the gate circuit, to control the value of constant current which said second constant current source transistor causes to flow, whereby signal propagation delay time of said gate circuit is variably set at a predetermined value,

the gate circuit device being further characterised by comprising a plurality of such gate circuits and having an input gate group, an internal gate group connected to the input gate group, an output gate group connected to the internal gate group, and a controller connected to the input gate group and the output gate group,

said plurality of gate circuits being provided in respect of the output gate group,

the controller being operable to measure respective time differences between input signals applied to the input gate group and respective corresponding output signals delivered from the output gate group and to provide control signals based on the respective time differences to respective terminal means of said plurality of gate circuits.

In one embodiment of the invention, the terminal means is arranged for receiving a control voltage as said control signal, and is arranged to apply that voltage to the base of the second constant current source transistor.

In another embodiment of the invention, the terminal means is arranged for receiving a control current as said control signal, and the device further comprises a current adjustment circuit means connected to said terminal means and said second constant current source transistor for causing, in response to said control current, current of a predetermined value to be generated in said second constant current source transistor.

An embodiment of the present invention provides that the delay time of an output signal, corresponding to an input signal, can be adjusted.

An embodiment of the present invention can provide a gate circuit device which can be employed in an IC tester as mentioned above so that the various output signals supplied to the output signal pins of the tester are generated simultaneously or in accordance with selected time intervals.

Such a gate circuit device outputs one of the various output signals, and is effectively a logic gate with an adjustment circuit capable of providing adjustment of the delay time between the output signal and the corresponding input signal; that is, to adjust the signal propagation delay time Tpd of the device to minutely alter output timing by operation of the adjustment circuit.

It will be understood that gate circuit devices in accordance with the present invention can find wider application than IC testers. They can be applied generally in cases in which signal timings may benefit from controlled adjustments of delay time.

Reference is made, by way of example, to the accompanying drawings, in which:-

Figures 1 and 3 are schematic circuit diagrams illustrating respective embodiments of the present invention and for assistance in explaining further embodiments of the present invention.

Figures 2 and 4 are graphs illustrating operational characteristics relating to embodiments of the present invention described with reference to Figs. 1 and 3;

Fig. 5 is a schematic block diagram illustrating one application of the present invention;

Fig. 6 is a schematic circuit diagram illustrating another embodiment of the present invention;

Fig. 7 is a graph illustrating operational characteristics of the embodiment of Fig. 6; and

Fig. 8 is a schematic circuit diagram of a further embodiment of the present invention for assistance also in more general explanation.

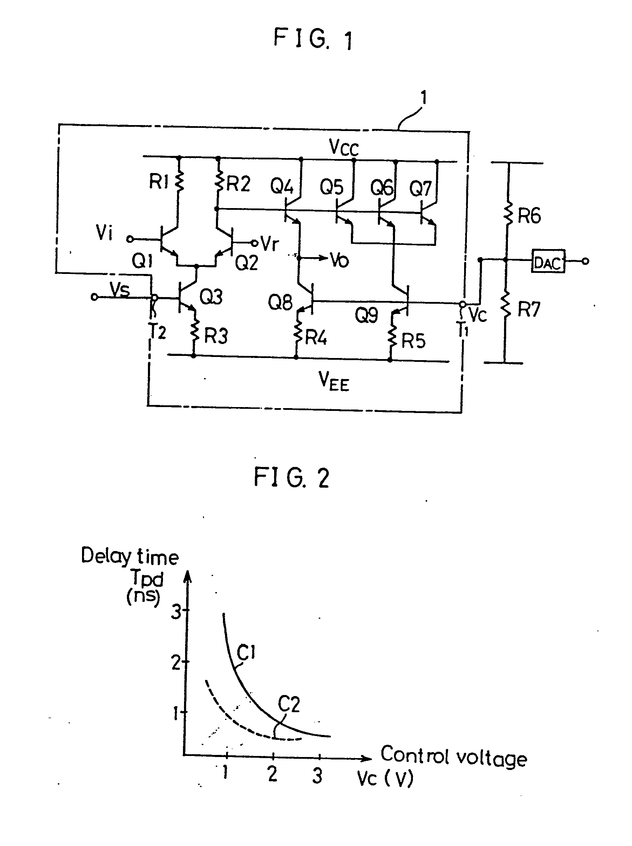

In the embodiment of the present invention shown in Fig. 1 a gate circuit device 1 has emitter coupled transistors Q1 and Q2, a constant current source transistor Q3, and resistors R1 to R3 which constitute an emitter coupled logic (ECL) or current switch circuit. Transistor Q8, which constitutes a constant current source, and a resistor R4 form a load for an output emitter follower transistor Q4. Vi is an input voltage for the logic gate circuit formed of the above-mentioned components, Vr is a reference voltage, Vo is an output voltage of the logic gate circuit, and Vs is a voltage which determines the value of constant current (provided by the transistor Q3).

Reference voltage Vr is a threshold voltage against which the state high (H) or low (L) of input voltage Vi is judged. When Vi is high relative to Vr, transistor Q1 turns on, transistor Q2 is turned off with output Vo in a high state, and when Vi is low relative to Vr, transistor Q1 turns off, transistor Q2 is turned on with output voltage Vo in a low state.

The output voltage Vo of the logic gate circuit mentioned above lags behind the input voltage Vi (a change in the output voltage lags behind the corresponding change in the input voltage) by a certain length of time. However, this lag or delay time (Tpd) is constant depending upon the value of current. To adjust current in the logic gate circuit an additional emitter follower circuit, comprising transistors Q5 to Q7, transistor Q9 and resistor R5, is connected in parallel with the output emitter follower circuit constituted by Q4, Q8, R4 which provides the output voltage of the logic gate circuit. The additional emitter follower circuit functions as a load capacitor, thus controlling the value of the current flowing in the load circuits Q8, Q9 (and R4, R5), by virtue of control voltage Vc applied to a terminal T1. Control voltage Vc is externally applied to the device 1 for example by a digital/analog converter DAC from which a constant voltage is derived by means of dividing resistors R6, R7.

Transistors Q5 to Q7 are connected in parallel, their bases being connected to an output terminal of the ECL circuit together with the base of transistor Q4. By this arrangement, the base capacitance of transistors Q5 to Q7 is connected to the output point (between R2 and Q2) of the ECL circuit, and delay time Tpd increases. The base capacitance of transistors Q5 to Q7 varies in dependence upon the value of current flowing through each of these transistors. Since transistor Q9 regulates, in dependence upon control voltage Vc, the value of current flowing through the transistors Q5 to Q7, the base capacitance of transistors Q5 to Q7 is regulated by the control voltage Vc, and consequently the delay time Tpd is adjustable by means of the externally applied control voltage Vc.

Further, since the control voltage Vc is also applied to the base of transistor Q8 of the output emitter follower circuit (Q4, Q8, R4) the value of current at the output terminal (of the logic gate circuit) is also regulated by control voltage Vc, so that delay time Tpd is made adjustable.

It will be understood that in a further embodiment of the present invention the transistors Q5 to Q7 and Q9 (and R5) can be omitted so that control voltage Vc is applied only to Q8 to control delay time Tpd.

It will further be understood that in another embodiment of the present invention, in which transistors Q5 to Q7 and Q9 are present, separate control voltages may be applied to Q8 and Q9, which may be adjustable simultaneously, or either one or both may be adjustable independently of the other.

In the embodiment of Fig. 1, delay time Tpd may also be adjusted by regulation of voltage Vs applied to terminal T2 and transistor Q3.

Vs and Vc may be adjusted simultaneously, or either one or both may be adjustable independently of the other.

In the embodiment illustrated in Fig. 1, when the control voltage Vc is set high, so as to increase current through transistors Q8, Q9, the emitter follower circuits work more rapidly, decreasing delay time Tpd. On the other hand, when the control voltage Vc is reduced, to reduce current through transistors Q8, Q9, the emitter follower circuits work more slowly, increasing delay time Tpd.

In Fig. 1, $V_{EE}$ and $V_{cc}$ are power supply voltages. The graph of Fig. 2 illustrates relationships of control voltage Vc and signal propagation delay time Tpd. In the graph, control voltage Vc (volts) appears on the abscissa whilst signal propagation delay time Tpd (nanoseconds) appears on the ordinate. Broken-line curve C2 indicates the delay characteristics when there is only one transistor Q8 as in Fig. 1 with transistors Q5 to Q7 and Q9 omitted, whilst solid-line curve C1 indicates delay characteristics with the load (additional emitter follower) circuit Q5 to Q9, R5 provided.

The number of transistors Q5, Q6... may be increased beyond the number shown in Fig. 1. The load capacitance increases accordingly and thus delay time Tpd increases.

In the circuitry of Fig. 1, control voltage Vc is commonly applied to transistor Q8 of the output emitter follower circuit (Q4, Q8, R4) and transistor Q9 of the load (additional emitter follower) circuit. However, if control voltage(s) Vc is (are) applied independently to transistors Q8, Q9, a finer adjustment of delay time can thereby be realized.

By the provision of the load circuit Q5 to Q7 as shown in Fig. 1, the range over which the delay time Tpd can be varied in accordance with a control voltage Vc is enlarged to make possible delay time adjustments of a higher degree of precision.

As mentioned above, delay time Tpd may also be adjusted by means of an externally applied regulating voltage Vs delivered to a terminal T2 of the device 1, which terminal is connected to the base of the constant current transistor Q3 of the ECL circuit comprising transistors Q1, Q2 etc. When Vs is increased, the ECL circuit works at a higher speed to decrease delay time whilst, on the other hand, when Vs is decreased the ECL circuit works at a lower speed to increase delay time Tpd.

Thus, in the illustrated embodiment of Fig. 1 delay time Tpd may be changed by adjusting control voltage Vc applied to terminal T1 or by adjusting regulating voltage Vs applied terminal T2. It is possible to adjust both voltages simultaneously or to regulate either one or both independently.

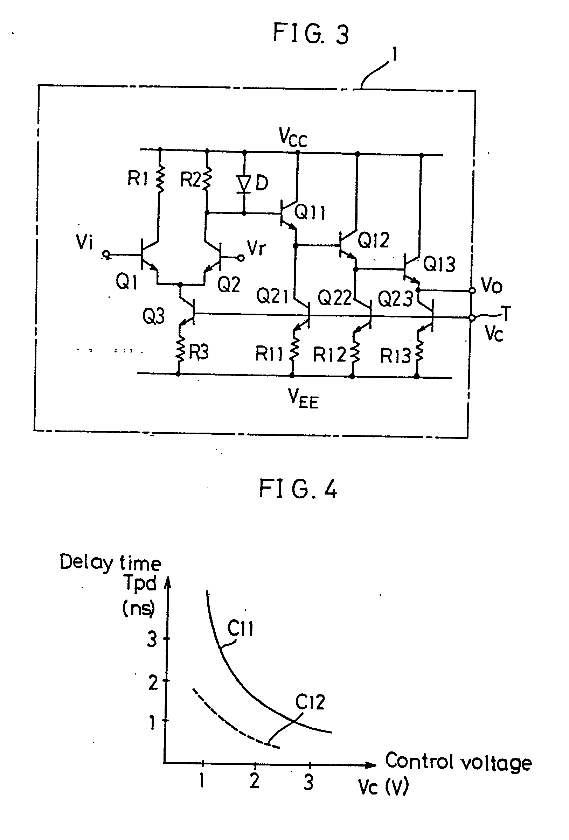

Fig. 3 illustrates another embodiment of the present invention.

In Fig. 3 components similar to components shown in Fig. 1 are designated by the same reference signs.

In Fig. 3, transistors Q11, Q21 and resistor R11, transistors Q12, Q22 and resistor R12, transistors Q13, Q23 and resistor R13 provide respective emitter follower circuits with transistors Q21 to Q23 forming constant current sources thereof. In other words, emitter follower circuitry of Fig. 1 is replaced by a three levels of emitter followers connected consecutively. Control voltage Vc is commonly applied, via a terminal T, to constant current transistors Q21 to Q23 of the emitter follower circuits of Fig. 3 and to the base of constant current source transistor Q3 of the ECL circuit. D is a diode.

In a further embodiment of the present invention, separate control voltages may be applied to constant current source transistor Q3 and constant current source transistors Q21 to Q23. The separate control voltages may be adjusted simultaneously, or one or both may be adjustable independently of the other.

In the circuitry of Fig. 3, when current to transistors Q3, Q21 to Q23 is increased by increasing control voltage Vc, the speeds at which the ECL circuit and the emitter follower circuits work is increased, to decrease delay time Tpd. When control voltage Vc is reduced opposite effects are achieved.

The graph Fig. 4 illustrates delay characteristics similarly to Fig. 2. In the graph of Fig. 4, the abscissa and ordinate are similar to those of the graph of Fig. 2.

In Fig. 4, curve C11 represents delay characteristics when the entire circuitry of Fig. 3 is regulated by control voltage Vc, whilst broken-line curve C12 represents the delay characteristics when the ECL circuit alone (Q3 alone) is so regulated. This shows that by regulating constant current transistors Q21 to Q23 of the emitter follower circuits simultaneously, rather than regulating only the base potential of constant current transistor Q3 of the ECL circuit, delay time Tpd may be increased to a greater extent for a given reduction of control voltage Vc. Further, it shows that, by providing several levels of emitter follower circuits, the overall delay time Tpd can be increased, and that high precision adjustment of delay time Tpd becomes possible by adjusting control voltage Vc.

It is possible to modify the circuitry of Fig. 3, as mentioned above, so that either one or both of the transistor Q3 and transistors Q21 to Q23 may be regulated independently.

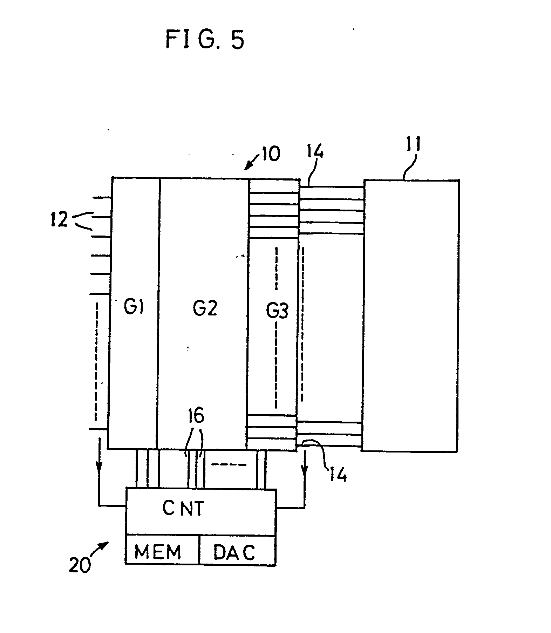

Fig. 5 illustrates an application of an embodiment of the present invention to an IC tester in which various signals are generated at a generator 10 having groups of input terminal pins 12, output terminal pins 14 and control terminal pins 16 respectively. Each pin 14 is connected to an integrated circuit (IC) 11 to be tested. Circuitry in accordance with an embodiment of the invention is employed in an output group G3, an input gate group G1 and an internal gate group G2 of the generator 10. Circuitry embodying the present invention (e.g. a device 1 as shown in Fig. 1 or Fig. 3) is provided for each output terminal pin 14. That is, each terminal pin has its own separate device 1. Thus, according to this application of the present invention, circuitry as in Fig. 1 or 3 provides each output gate of the group G3. There is provided a controller 20 comprising a control circuit CNT having counter means which measures the time difference between input and output signals per each input (12) and output (14) terminal pin, that is, delay time Tpd, an operation circuit for calculating delay time amounts to be added as necessary to equalize delay times Tpd for all output terminal pins, and a table, memory MEM in which is stored (in digital terms) values for control voltages Vc for each output terminal pin, and digital/analog converter DAC which converts digital control voltage values to analog voltages. There are provided as many digital/analog converters DAC as there are output terminal pins, each converter with register means at its input side into which register data read out from memory is set so that, in testing an integrated circuit, control voltages Vc for all the terminal pins are output from the digital/analog converters DAC. A circuit to generate designated control voltage Vc may be provided at each terminal pin (T1, T) connected to a circuit as in Fig. 1 or Fig. 3, with only one digital/analog converter DAC, as seen in Fig. 5, for designating control voltages Vc for each terminal pin. The circuits for generating control voltages Vc provide the designated voltages to each terminal pin (T1, T). If delay of output level gate circuit of Fig. 1 and Fig. 3 is made constant, the measurement of above delay time Tpd and determination of control voltage Vc are done only once, thus making it possible to output from said IC tester various test voltages correctly and at the same time.

Test signal generator 10 and controller 20 may be fabricated in one LSI or in one individual IC. If they are fabricated each in an individual IC device terminal T or T1 which receives control voltage Vc becomes an external terminal pin of the test signal generator IC.

In the embodiments of the invention so far described, adjustment of delay time is effect by applying control voltage to the constant current transistor of the ECL, or current switch, circuit and/or to the base of the or each constant current source transistor of the or each output (emitter follower) circuit. Because of this, current in either the current switch (ECL) circuit or the or each emitter follower circuit does not change linearly in response to a change of control voltage. Thus, in a certain range of control voltage values, the ratio of change of current (to change of control voltage) is too large, and in another range of control voltage values said ratio is too small. Where base potential is regulated, it is difficult to set the available range of current change sufficiently wide. Further, it is desirable to minimize errors in setting values of current arising due to variations of control voltage and resistance of wirings.

It is therefore desirable to regulate base current for example of the (constant current source) transistor placed in an emitter follower circuit so that current in the emitter follower circuit changes linearly in response to control voltage.

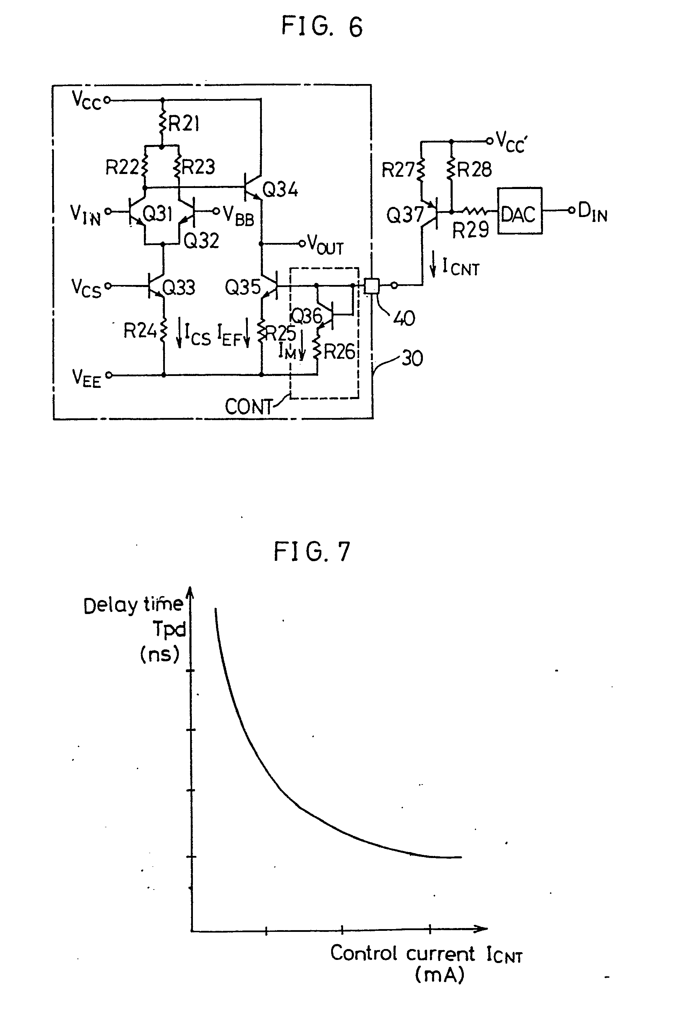

In the embodiment of the present invention shown in Fig. 6 there is provided a current switch circuit (an ECL circuit) having emitter coupled transistors Q31, Q32, transistor Q33 providing a constant circuit or source and resistors R21, R22, R23, R24, an emitter follower circuit having transistors Q34, Q35 and resistor R25, a control current supply circuit having a PNP type transistor Q37, resistors R27, R28, R29, and a digital/analog converter DAC, and a base current adjustment circuit which is a series circuit of a transistor Q36 and a resistor R26, with transistor Q36 connected between the base of current control transistor Q35 of the emitter follower circuit and the control current supply circuit. 30 indicates an integrated circuit device, for example, which is arranged to receive an externally provided current $I_{CNT}$ through a terminal of the device, from the control current supply circuit. An input signal $V_{IN}$ is supplied to the base of transistor Q31 of the current switch circuit, i.e. the ECL circuit, and a reference voltage $V_{BB}$ is applied to the base of transistor Q32. A bias voltage $V_{CS}$ (c.f. Vs above), generated internally or externally, is applied to the base of transistor Q33 of the constant current circuit or source.

In the circuit of Fig. 6, when the voltage of the input signal $V_{IN}$ is higher than reference voltage $V_{BB}$, transistor Q31 turns on with transistor Q32 turned off, and a low level output signal voltage $V_{OUT}$ is obtained from the emitter of transistor Q34. On the other hand, when voltage of the input signal $V_{IN}$ is lower than reference voltage $V_{BB}$, transistor Q31 is turned off with transistor Q32 on, and is a high level output signal voltage $V_{OUT}$ is obtained.

On the other hand, a digital control signal $D_{IN}$ input to digital/analog converter DAC is converted into an analog voltage by the converter DAC and is applied to the base of transistor Q37 via resistor R29. Control current $I_{CNT}$ corresponding to this analog voltage flows through the collector of transistor Q37 which current flows via terminal 40 to the base of transistor Q35 and transistor Q36 of the base current adjustment circuit CONT.

Now, where transistors Q35 and Q36 have the same characteristics, there is a relationship as follows:

$$I_{CNT} / 2 = I_{EF} = I_M$$

where $I_{EF}$ is emitter current of transistor Q35 and is equal to the current of the emitter follower circuit, and $I_M$ is current of the base current adjustment circuit CONT. That is, it becomes possible to adjust linearly the current of the emitter follower circuit comprised of transistors Q34, Q35 and resistor R25 by control current $I_{CNT}$. Also, the base current adjustment circuit CONT comprising transistor Q36 and resistor R26 is in a current mirror relationship to the emitter follower circuit (relative to the control signal).

As explained above, it becomes possible, by adjusting the externally provided control current $I_{CNT}$ in response to the control signal $D_{IN}$ and by causing current $I_{EF}$ of the internal emitter follower circuit to vary, to adjust signal propagation delay time of the emitter follower circuit and thereby to adjust difference of delay time between input signal $V_{IN}$ and output signal $V_{OUT}$.

Fig. 7 is a graph illustrating one example of a relationship between delay time Tpd between input signal $V_{IN}$ and output signal $V_{OUT}$ relative to control current $I_{CNT}$, for the embodiment of Fig. 6.

In the embodiment of Fig. 6, delay time is adjusted by varying the current of the emitter follower circuit by means of control current $I_{CNT}$. It will be clear that adjustment of delay time is possible by adjustment (also or alternatively) of current in the current switch (ECL) circuit. In this case, it is sufficient if control current $I_{CNT}$ is sent to the base of current source transistor Q33 in Fig. 6. Further, current of the emitter follower circuit and current of the current switch circuit may be adjusted together.

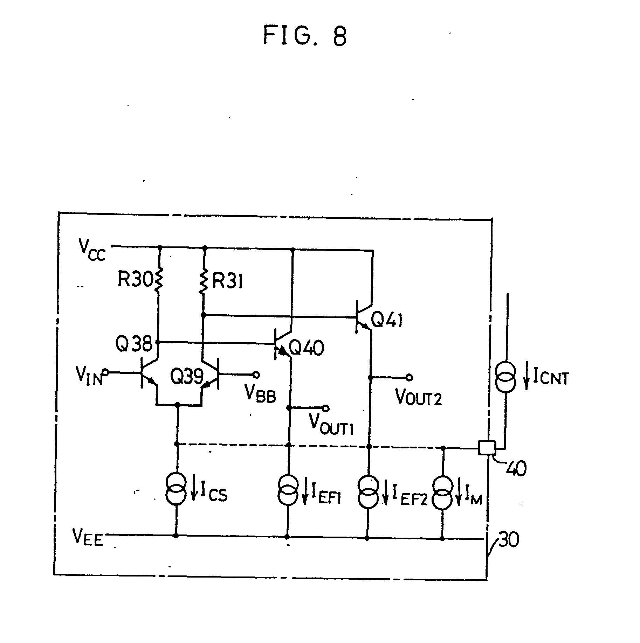

In other words, referring to the more general aspect of the arrangement shown in Fig. 8, any one of currents $I_{EF1}$ and $I_{EF2}$ of emitter follower circuits and current $I_{CS}$ of the current switch (ECL) circuit may be adjusted, or each of these currents, or several of these currents may be adjusted simultaneously. In such cases, a transistor of each current source (corresponding to $I_{EF1}$, $I_{EF2}$, $I_{CS}$) forms a current mirror circuit together with the base current adjustment circuit CONT such as the one shown in Fig. 6.

In relation to the more particular aspect of the arrangement of Fig. 8, the current switch (ECL) circuit comprises transistors Q38, Q39, resistors R30, R31 and constant current circuit $I_{CS}$ whilst transistor Q40 and constant current circuit $I_{EF1}$ form a first emitter follower circuit, and transistor Q41 and the current source circuit $I_{EF2}$ form a second emitter follower circuit. The arrangement of Fig. 8 provides two outputs, $V_{OUT1}$ and $V_{OUT2}$,

from the first and second emitter follower circuits, which are connected to collectors of different transistors Q38, Q39 of the ECL circuit. Further, each of the current source circuits $I_{CS}$, $I_{EF1}$, $I_{EF2}$ may comprise a transistor and a resistor in the same manner as in Fig. 6 (e.g. transistor Q35 and resistor R25) in which case control current $I_{CNT}$ is supplied to the base of each transistor. Moreover, the current source circuit $I_M$ in Fig. 8 corresponds to the base current adjustment circuit of Fig. 6.

The embodiments of the present invention explained with reference to Figs. 1 and 3 have the technical effect that, by adding a circuit for adjusting signal propagation delay time Tpd to a logic gate circuit, simultaneous outputting of signals can be realised by using such gate circuits at an output level of an IC tester for example. In the embodiments of the present invention explained with reference to Figs. 6 and 8, current in the current switch (ECL) circuit and/or in the or a emitter follower circuit is adjusted by current supplied from a control current generating circuit with said control current generating circuit being formed as a current source circuit, and current of the current switch (ECL) circuit and/or current of the or a emitter follower circuit concerned is linearly varied relative to the control signal. Because of this, delay time of the circuit is correctly and easily adjusted. Further, since delay time is adjusted by a control current, there is no effect from the resistance of wirings and unevenness of base voltage in setting up delay time. In Figs. 1 and 3, voltage control of signal propagation delay time is used, whilst in Figs. 6 and 8 current control is used.

## Claims

1. A gate circuit device comprising:
a gate circuit having a pair of emitter coupled transistors (Q1, Q2; Q31, Q32; Q38, Q39), a first constant current source transistor (Q3; Q33) connected to the emitter side of said emitter coupled transistors, emitter follower output level circuitry (Q4 to Q7, Q8, Q9; Q11 to Q13, Q21 to Q23; Q34, Q35; Q40, Q41) connected to the collector of one of said emitter coupled transistors, a second constant current source transistor (Q8, Q9; Q21 to Q23; Q35) provided in said emitter follower output level circuitry, and characterised by a terminal means (T1, T, 40) arranged for receiving a selectively variable control signal, from outside the gate circuit, to control the value of constant current which said second constant current source transistor causes to flow, whereby signal propagation delay time of said gate circuit is variably set at a predetermined value,
the gate circuit device being further characterised by comprising a plurality of such gate circuits and having an input gate group (G1), an internal gate group (G2) connected to the input gate group, an output gate group (G3) connected to the internal gate group, and a controller (20) connected to the input gate group and the output gate group,

said plurality of gate circuits being provided in respect of the output gate group,
the controller being operable to measure respective time differences between input signals applied to the input gate group and respective corresponding output signals delivered from the output gate group and to provide control signals based on the respective time differences to respective terminal means of said plurality of gate circuits.

2. A gate circuit device as claimed in claim 1, wherein, in each gate circuit, the terminal means (T1, T) is arranged for receiving a control voltage as said control signal, and is arranged to apply that voltage to the base of the second constant current source transistor (Q8, Q9; Q21 to Q23).

3. A gate circuit device as claimed in claim 1, wherein, in each gate circuit, the terminal means (40) is arranged for receiving a control current as said control signal, and wherein the device further comprises a current adjustment circuit means (CONT) connected to said terminal means (40) and said second constant current source transistor (Q35) for causing, in response to said control current, current of a predetermined value to be generated in said second constant current source transistor.

4. A gate circuit device as claimed in claim 3, wherein, in each gate circuit, said second constant current source transistor (Q35) and a transistor (Q36) of said current adjustment circuit means form a current mirror.

## Patentansprüche

1. Torschaltungsanordnung mit:
einer Torschaltung, die ein Paar von emittergekoppelten Transistoren (Q1, Q2; Q31, Q32; Q38, Q39) hat, einem ersten Konstantstromquellentransistor (Q3, Q33), der mit der Emitterseite der emittergekoppelten Transistoren verbunden ist, einer Emitterfolger-Ausgangspegelschaltung (Q4 bis Q7, Q8, Q9; Q11 bis Q13, Q21 bis Q23; Q34, Q35; Q40, Q41), die mit dem Kollektor von einem der genannten emittergekoppelten Transistoren verbunden ist, einem zweiten Konstantstromquellentransistor (Q8, Q9; Q21 bis Q23; Q35), der in der genannten Emitterfolger-Ausgangspegelschaltung vorgesehen ist, und gekennzeichnet durch eine Anschlußeinrichtung (T1, T, 40), die angeordnet ist, um ein selektiv variables Steuersignal von außerhalb der Torschaltung zu empfangen, um den Wert des Konstantstromes zu steuern, dessen Fluß der genannte zweite Konstantstromquellentransistor verursacht, wodurch eine Signalfortpflanzungsverzögerungszeit der genannten Torschaltung variabel auf einen vorbestimmten Wert gesetzt wird,
wobei die Torschaltungsanordnung ferner gekennzeichnet ist durch eine Vielzahl von solchen Torschaltungen und eine Eingangstorgruppe (G1), eine interne Torgruppe (G2), die mit der Eingangstorgruppe verbunden ist, eine Ausgangstorgruppe (G3), die mit der internen Torgruppe verbunden ist, und einen Controller (20) hat, der mit der Eingangstorgruppe und der Ausgangstorgruppe verbunden ist,

wobei die genannte Vielzahl von Torschaltungen in Bezug auf die Ausgangstorgruppe vorgesehen ist,

der Controller betreibbar ist, um jeweilige Zeitdifferenzen zwischen den Eingangssignalen, die der Eingangstorgruppe zugeführt werden, und entsprechenden Ausgangssignalen, die von der Ausgangstorgruppe geliefert werden, zu messen, und um Steuersignale vorzusehen, basierend auf den jeweiligen Zeitdifferenzen zwischen den entsprechenden Anschlußeinrichtungen der genannten Vielzahl von Torschaltungen.

2. Torschaltungsanordnung nach Anspruch 1, bei der, in jeder Torschaltung, die Anschlußeinrichtung (T1, T) angeordnet ist, um eine Steuerspannung als das genannte Steuersignal zu empfangen, und angeordnet ist, um jene Spannung auf die Basis des zweiten Konstantstromquellentransistors (Q8, Q9; Q21 bis Q23) aufzubringen.

3. Torschaltungsanordnung nach Anspruch 1, bei der, in jeder Torschaltung, die Anschlußeinrichtung (40) angeordnet ist, um einen Steuerstrom als das genannte Steuersignal zu empfangen, und bei der die Vorrichtung ferner eine Stromeinstellschaltungseinrichtung (CONT) umfaßt, die mit der genannten Anschlußeinrichtung (40) und dem genannten zweiten Konstantstromquellentransistor (Q35) verbunden ist, um zu bewirken, daß in Abhängigkeit von dem genannten Steuerstrom ein Strom von einem vorbestimmten Wert in dem genannten zweiten Konstantstromquellentransistor erzeugt wird.

4. Torschaltungsanordnung nach Anspruch 3, bei der, in jeder Torschaltung, der genannte zweite Konstantstromquellentransistor (Q35) und ein Transistor (Q36) von der genannten Stromeinstellschaltungseinrichtung einen Stromspiegel bilden.

**Revendications**

1. Dispositif à circuit de porte comportant:

un circuit de porte comprenant une paire de transistors à couplage d'émetteur (Q1, Q2; Q31, Q32; Q38, Q39), un premier transistor source de courant constant (Q3; Q33) connecté au côté d'émetteur desdits transistors à couplage d'émetteur, un circuit de niveau de sortie à suiveur d'émetteur (Q4 à Q7, Q8, Q9; Q11 à Q13, Q21 à Q23; Q34, Q35; Q40, Q41) connecté au collecteur de l'un desdits transistors à couplage d'émetteur, un second transistor source de courant constant (Q8, Q9; Q21 à Q23; Q35) prévu dans ledit circuit de niveau de sortie à émetteur suiveur, caractérisé par un dispositif terminal (T1, T, 40) agencé pour recevoir un signal de commande variable sélectivement provenant de l'extérieur du circuit de porte pour commander la valeur du courant constant que ledit second transistor source de courant constant fait circuler de manière que le temps de retard de propagation du signal dudit circuit de porte soit réglé de façon variable à une valeur prédéterminée,

le dispositif à circuit de porte étant en outre caractérisé en ce qu'il comporte plusieurs de ces circuits de porte et comprenant un groupe de portes d'entrée (G1), un groupe de portes internes (G2) connecté au groupe de portes d'entrée, un groupe de portes de sortie (G3) connecté au groupe de portes internes et un moniteur (20) connecté au groupe de portes d'entrée et au groupe de portes de sortie,

lesdits plusieurs circuits de porte étant prévus par rapport au groupe de portes de sortie,

le moniteur ayant pour fonction de mesurer des différences de temps respectives entre des signaux d'entrée appliqués au groupe de portes d'entrée et des signaux de sortie correspondants respectifs délivrés par ledit groupe de portes de sortie et de produire des signaux de commande basés sur les différences de temps respectives pour le dispositif terminal respectif desdits plusieurs circuits de porte.

2. Dispositif à circuit de porte selon la revendication 1, dans lequel, dans chaque circuit de porte, le dispositif terminal (T1, T) est agencé pour recevoir une tension de commande comme ledit signal de commande et est agencé pour appliquer cette tension à la base du second transistor source de courant constant (Q8, Q9; Q21 à Q23).

3. Dispositif à circuit de porte selon la revendication 1, dans lequel, dans chaque circuit de porte, le dispositif terminal (40) est agencé pour recevoir un courant de commande comme ledit signal de commande et dans lequel le dispositif comporte en outre un dispositif de circuit de réglage de courant (CONT) connecté audit dispositif terminal (40) et audit second transistor source de courant constant (Q35) pour provoquer, en réponse audit courant de commande, qu'un courant d'une valeur prédéterminée soit produit dans ledit second transistor source de courant constant.

4. Dispositif à circuit de porte selon la revendication 3, dans lequel, dans chaque circuit de porte, ledit second transistor source de courant constant (Q35) et un transistor (Q36) dudit dispositif de circuit de réglage de courant forment un miroir de courant.

# F I G. 1

# F I G. 2

## FIG. 3

## FIG. 4

# FIG. 5

## FIG. 6

## FIG. 7

# FIG. 8